# EUROPÄISCHE PATENTANMELDUNG

(11) **EP 1 970 932 A2**
(43) Veröffentlichungstag der Anmeldung: **17.09.2008**
(21) Anmeldenummer: 08100571.2
(22) Anmeldetag: 17.01.2008
(51) Int. Cl.: H01H 37/76

(54) **Vorrichtung zur thermischen Überwachung eines Bauelementes**

(30) Priorität: 14.03.2007 DE 102007012345
(71) Anmelder: Siemens AG Österreich, 1210 Wien (AT)
(72) Erfinder: Cesnak, Lorand, 1050 Wien (AT); Cyba, Edward, 1020 Wien (AT)

(57) **Zusammenfassung**

Vorrichtung zur thermischen Überwachung eines Bauelementes (2) in einem elektrischen Strompfad (8), umfassend:
- ein mit dem Bauelement (2) wärmeleitend verbundenes Schmelzelement (3);
- eine mit dem Schmelzelement (3) in einer Wirkverbindung stehende Unterbrechungseinrichtung (14), die den Strompfad (8) unterbricht, für den Fall, dass die Temperatur des Bauelementes (2) einen vorgegebenen Schwellwert überschreitet, so dass das Schmelzelement (3) schmilzt;

**dadurch gekennzeichnet,**
- dass das Schmelzelement (3) am Bauelement (2) anliegend angeordnet ist, und
- dass ein Federsystem (5, 6) vorgesehen ist, mittels dessen das Schmelzelement (3) mit einer zum Bauelement (2) gerichteten Federkraft beaufschlagbar ist.

## Beschreibung

### Technisches Gebiet

Die Erfindung betrifft eine Vorrichtung zur thermischen Überwachung eines Bauelementes in einem Strompfad, mit einem mit dem Bauelement wärmeleitend verbundenen Schmelzelement, mit einer mit dem Schmelzelement in einer Wirkverbindung stehenden Unterbrechungseinrichtung, die den Strompfad unterbricht, für den Fall, dass die Temperatur des Bauelementes einen vorgegebenen Schwellwert überschreitet, so dass das Schmelzelement geschmolzen ist.

### Stand der Technik

Um ein Bauelement, beispielsweise ein Leistungs-Halbleiterbauelement oder einen elektrischen Widerstand vor thermischer Überlastung zu sichern, sind verschiedene Temperatursicherungen und Thermoschalter bekannt.

Aus der DE 42 41 311 C2 ist ein Temperaturschalter für einen Varistor bekannt, der eine Anschlussfahne aufweist, die mittels einer Lötverbindung mit einem beweglichen Anschlusselement, das mit einer Federkraft beaufschlagt ist, mechanisch und elektrisch verbunden ist. Wenn sich der Varistor bei Betrieb erwärmt, so gelangt diese Betriebswärme nach einer gewissen Zeit über die Anschlussfahne auch an die Lötverbindung. Sobald das Lot an der Verbindungsstelle die Schmelztemperatur erreicht hat, schmilzt das Lot. Die Verbindung zwischen der Anschlussfahne und dem Anschlusselement wird durch Federkraft getrennt. Damit wird der Strompfad zum Varistor automatisch unterbrochen.

Es gibt bestimmte Überwachungsfälle, in denen dieser Mechanismus des automatischen "Auslötens" nicht anwendbar ist. Aus Gründen der Brandsicherheit kann beispielsweise eine Überwachungstemperatur gefordert sein, die unterhalb der Schmelztemperatur eines herkömmlich verwendeten Lots liegt. Von Nachteil ist der Temperaturunterschied zwischen dem Bauelement und der Verbindungsstelle. Außerdem benötigt die Wärmeleitung zu einer vom Bauelement örtlich getrennten Verbindungsstelle Zeit, was zu einem verzögerten Ansprechen führt.

### Darstellungen der Erfindung

Aufgabe der vorliegenden Erfindung ist es, eine Vorrichtung zur thermischen Überwachung eines Bauelementes anzugeben, die möglichst einfach aufgebaut ist, die tatsächlich wirksame Bauteiltemperatur erfasst und eine kurze Ansprechzeit aufweist.

Diese Aufgabe wird durch eine Vorrichtung mit den Merkmalen des Patentanspruchs 1 gelöst. Vorteilhafte Ausgestaltungen der Erfindung sind in den abhängigen Ansprüchen definiert.

Die erfindungsgemäße Lösung sieht vor, dass am Bauelement direkt ein Schmelzelement anliegend angeordnet ist, wobei das Schmelzelement mit einem Strompfad-Unterbrechungsmittel zusammen wirkt, und wobei ein Federsystem vorgesehen ist, mittels dessen das Schmelzelement mit einer zum Bauelement gerichteten Federkraft beaufschlagbar ist.

Im Gegensatz zum Stand der Technik, bei dem eine durch das Lot gebildete elektrische und mechanische Verbindungsstelle zwischen Kontakten aufgetrennt wird, erfolgt gemäß der Erfindung das Erfassen der Bauteil-Übertemperatur und das Trennen des Strompfades durch getrennte Mittel: Die Temperatur wird durch ein Schmelzelement erfasst, das erfindungsgemäß anliegend am Bauelement, d.h. außerhalb des Strompfades angeordnet ist, so dass nichtleitende niedrigschmelzende Werkstoffe eingesetzt werden können; das Auftrennen des Strompfades erfolgt durch eine separate Unterbrechungseinrichtung. Im Überlastfall wird erdfindungsgemäß der Schmelzvorgang beschleunigt, indem das Schmelzmaterial mit Federkraft in Richtung der Wärmequelle, d.h. zum überwachenden Bauelement hin bewegt wird. Dadurch kommt es im Zuge des Erweichens des Schmelzwerkstoffs zu einer sich zunehmend vergrößernden Wärmekontaktfläche, was eine rasche Auslösezeit begünstigt.

Eine vorteilhafte Ausgestaltung der Erfindung kann so ausgeführt sein, dass das Bauelement auf einem plattenförmigen Schaltungsträger angeordnet ist und sich das Federmittel auf diesem Träger abstützt.

Eine bevorzugte Ausführungsform der Erfindung kann dadurch gekennzeichnet sein, dass das Federsystem durch zwei Federzungen gebildet ist. Jede dieser Federzungen presst mit einer Flachseite jeweils eine Schmelzpille gegen das zu überwachende Bauelement. Am gegenüberliegenden Ende einer jeden Federzunge ist jeweils ein elektrischer Kontakt ausgebildet, der bei thermischer Überlast die Unterbrechungseinrichtung veranlasst, das Bauelement von der Stromversorgung zu trennen.

Hierbei kann es insbesondere bei einem hohen Schaltstrom vorteilhaft sein, wenn dieser elektrische Kontakt ein Schließkontakt ist, der beispielsweise ein Relais oder eine andere Schalteinrichtung veranlasst, den Strompfad zum Bauelement aufzutrennen. Dadurch wird verhindert, dass es, auf Grund der sich gemäß dem Schmelzvorgang langsam aufeinander zu bewegenden Kontakte, zu einer Funkenbildung kommt.

Wenn im Strompfad ein, bezüglich des unterbrechenden Schaltmittels, niedriger Strom geführt wird, kann es vorteilhaft sein, wenn der elektrische Kontakt als Öffnungskontakt ausgebildet ist. Dadurch kann der Strompfad auf einfache Weise direkt unterbrochen werden.

Bei einer anderen bevorzugten Ausführungsform kann vorgesehen sein, dass das Federmittel aus einem einzigen U-förmigen Federbügel besteht.

Hierbei kann es konstruktiv günstig sein, wenn dieser Federflügel mit einem Einspannende auf dem Träger befestigt ist, und der andere Schenkel, frei beweglich als Druckschenkel wirkt; der Federweg des Druckschenkels kann für die Betätigung des Unterbrechungsmittels herangezogen werden.

Die Verwendung eines polymeren Werkstoffs ermöglicht die Realisierung einer Überwachungseinrichtung, deren Temperatur-Schwellwert weit unterhalb der Schmelztemperatur eines metallischen Elektroniklots, von etwa 180 Grad liegt.

Hierbei bietet sich insbesondere aus Kostengründen die Verwendung eines kommerziellen Schmelzklebstoffs (auch als "Hot Melt" bezeichnet) an, wie er üblicherweise in Klebepistolen zum Herstellen einer Klebverbindung verwendet wird. Das Schmelzmaterial kann beispielsweise ein Polyamid, ein Polyethylen oder beispielsweise ein Polyester-Elastomer sein.

Handelsüblich sind zylinderförmige Stangen des Schmelzklebstoffs, aus denen auf einfache Weise scheibenförmige Schmelzpillen vorgebbarer Dicke hergestellt werden können. Diese Schmelzpillen werden bevorzugt in eine Eintiefung, die auf einer Blattfeder des Federsystems vorgesehen ist, eingelegt. Die Blattfeder ist bevorzugt in Blech-Biegestanztechnik hergestellt.

### Kurzbeschreibung der Zeichnungen

Zur weiteren Erläuterung der Erfindung wird im nachfolgenden Teil der Beschreibung auf die Zeichnungen Bezug genommen in denen weitere vorteilhafte Ausgestaltungen, Einzelheiten und Weiterbildungen der Erfindung zu entnehmen sind.
Es zeigt:
- Figur 1: ein erstes Ausführungsbeispiel in einer perspektivischen Darstellung;
- Figur 2: eine Seitenansicht der Figur 1;
- Figur 3: eine Federzunge, bei der der elektrische Kontakt als Schließkontakt ausgebildet ist;
- Figur 4: ein zweites Ausführungsbeispiel der Erfindung in einer schematischen Ansicht.

### Ausführung der Erfindung

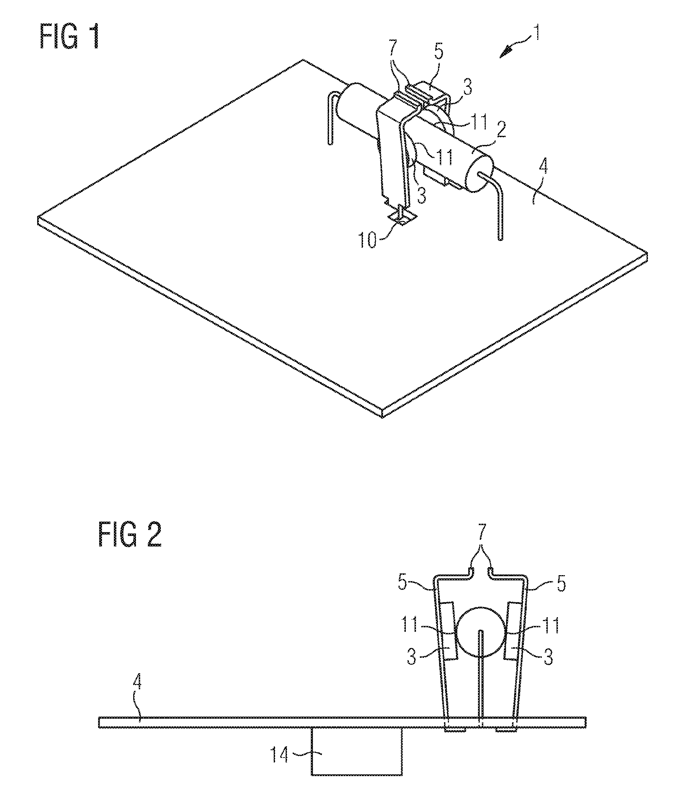

In der Figur 1 ist mit dem Bezugszeichen 1 im gesamten eine Überwachungsvorrichtung zur thermischen Überwachung eines Bauelementes 2 bezeichnet. Das Bauelement 2 ist ein elektrischer Widerstand zylindrischer Bauform. Der Widerstand 2 ist in einem Abstand zu einer Platine 4 angeordnet und über seine Anschlüsse in einen hier nicht näher dargestellten Strompfad integriert. Beidseits der Mantelfläche des Widerstandes 2 sind zwei zungenförmige Federn 3 zu sehen, die in einer Ausnehmung 10 auf der Leiterplatte 4 eingesteckt und dort befestigt werden können. Zwischen jeder Federzunge 3 und der zylindrischen Mantelfläche des Widerstands 2 ist jeweils eine zylinderförmige Schmelzpille 3 angeordnet. Jede dieser Schmelzpillen 3 besteht aus einem Polymerwerkstoff und wird mit der Kraft der Feder 5 an den Widerstand 2 gepresst. Wenn sich der Widerstand 2 bei Betrieb erwärmt, so wird diese Wärme in die Schmelzpille 3 eingetragen. Sobald die Schmelztemperatur im Bereich der Anlage überschritten ist, beginnt sich der Kunststoff zu erweichen und es bildet sich eine breiige Schmelzzone 11 aus. Die Kraft der Feder 5 schiebt die Schmelzpille 3 immer mehr in Richtung des Bauelementes 2, so dass die anfängliche Linienberührung zwischen der zylindrischen Mantelfläche des Widerstandes 2 sich flächig ausbreitet und die gekrümmte Kontur des Bauelements 2 immer mehr in die anfangs plane Stirnfläche der Schmelzpille eintaucht. Damit ist für den Wärmetransport eine immer größere Kontaktfläche wirksam. Dieser Effekt verstärkt sich durch die Federkraft, so dass die Schmelzzone 11 und damit der Schmelzvorgang des Schmelzelementes insgesamt rasch zunimmt. Infolgedessen kommt es zu einer vergleichsweise schnellen Annäherung der galvanischen Kontakte 7, die endseitig an der Feder 5 ausgebildet sind. Sind diese Kontakte 7 geschlossen, so wird mittels einer Unterbrechungseinrichtung 14 (Figur 2) der Widerstand 2 von der Energieversorgung getrennt. Das Schließen der elektrischen Kontakte 7 kann auch durch eine nicht näher dargestellte Anzeigevorrichtung angezeigt bzw. einem übergeordneten Überwachungssystem gemeldet werden. Selbstverständlich kann auch der Kontakt 7 auch anders ausgebildet sein, z.B.: als Öffner, sofern der Schaltstrom mit langsam sich öffnenden Kontakten handhabbar ist. In diesem Fall fungiert der Kotakt 7 als Unterbrechungseinrichtung. Es versteht sich von selbst, dass an einer zu überwachenden Funktionseinheit 2 mehrere dieser Überwachungseinrichtungen 1 vorgesehen sein können.

Die Figur 2 zeigt eine Seitenansicht des oben erläuterten ersten Ausführungsbeispiels der Erfindung.

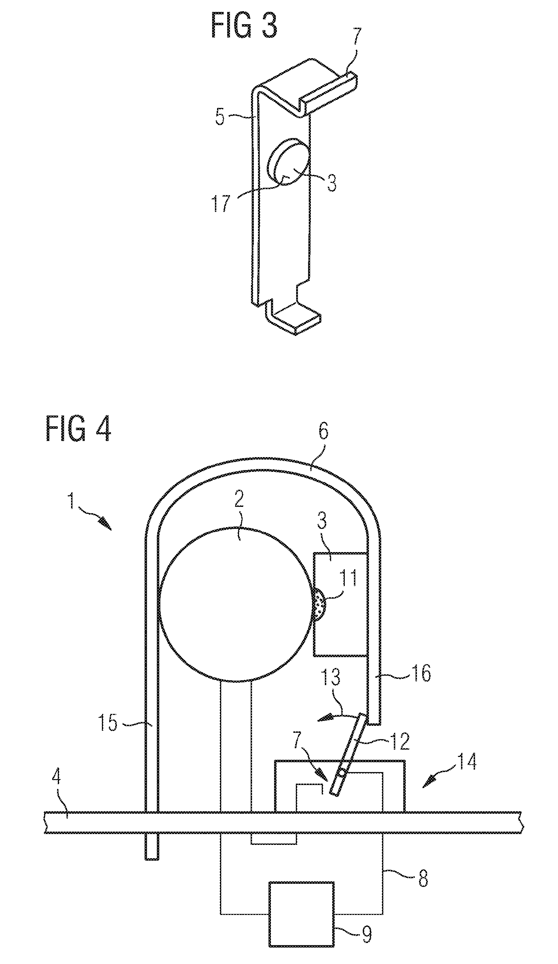

In der Figur 3 ist eines der beiden zungenförmigen Federelemente 5 perspektivisch gezeichnet. Die zylindrische Schmelzpille 3 ist in Figur 3 in einer Eintiefung 17 der Blattfeder 5 angeordnet.

In der Figur 4 ist eine zweite Ausführungsform der Erfindung skizziert. Hier besteht das Federsystem aus einem einzigen Federbügel 6, der sich über das Bauelement 2 dachförmig wölbt. An einem Ende ist der Federbügel 6 auf der Leiterplatte 4 eingespannt (Einspannschenkel 15). Der andere Schenkel (Druckschenkel 16) drückt mit Federkraft die Schmelzpille 3 in Richtung des zylindrischen Bauelementes 2.

Auch hier wird durch die Vorspannung der Feder 6 im Überlastfall die Schmelzpille 3 mit der sich ausbreiten Schmelzzone 11 in Richtung des Bauelements 2 gepresst, so dass der Schmelzvorgang verstärkt wird. In Figur 4 ist ein Schalthebel 12 zu sehen, der vom freien Ende des Druckschenkels 16 betätigt wird, wenn die Schmelzmasse 3 sich verflüssigt und abtropft. (Da der abtropfende Kunststoff elektrisch nicht leitend ist, ist dies für die Funktionsfähigkeit der elektrischen Schaltung auf der Leiterplatte 4 ohne Belang). Der Schmelzvorgang gibt den Federweg des Druckschenkels 16 immer mehr frei, wodurch der Kontakt 7 (z.B.: ein Kippschalter) sich öffnet (Pfeil 13), so dass in diesem Ausführungsbeispiel der Strompfad 8 direkt unterbrochen und der Widerstand 2 von der Energieversorgung 9 getrennt wird. Der Schmelzen der Pille 3 ist irreversibel, die Feder 5 bzw. 6 kann aber manuell zurück gebogen und mit einer neuen Pille bestückt werden.

Die erfindungsgemäße Vorrichtung ist konstruktiv einfach und kann mit geringem Aufwand hergestellt werden. Durch geeignete Wahl eines Schmelzwerkstoffes kann auch eine Betriebstemperatur von unter 100 Grad Celsius zuverlässig überwacht werden.

### Zusammenstellung der verwendeten Bezugszeichen

- 1: Überwachungsvorrichtung
- 2: Bauelement
- 3: Schmelzpille
- 4: Träger, Leiterplatte
- 5: Federzunge
- 6: Federbügel
- 7: elektrischer Kontakt
- 8: Strompfad
- 9: Energiequelle
- 10: Ausnehmung in 4
- 11: Schmelzzone
- 12: Hebel
- 13: Pfeil
- 14: Unterbrechungseinrichtung
- 15: Einspannschenkel
- 16: Druckschenkel
- 17: Eintiefung

## Patentansprüche

1. Vorrichtung zur thermischen Überwachung eines Bauelementes (2) in einem elektrischen Strompfad (8), umfassend:
- ein mit dem Bauelement (2) wärmeleitend verbundenes Schmelzelement (3);
- eine mit dem Schmelzelement (3) in einer Wirkverbindung stehende Unterbrechungseinrichtung (14), die den Strompfad (8) unterbricht, für den Fall, dass die Temperatur des Bauelementes (2) einen vorgegebenen Schwellwert überschreitet, so dass das Schmelzelement (3) schmilzt;
**dadurch gekennzeichnet,**
- **dass** das Schmelzelement (3) am Bauelement (2) anliegend angeordnet ist, und
- **dass** ein Federsystem (5, 6) vorgesehen ist, mittels dessen das Schmelzelement (3) mit einer zum Bauelement (2) gerichteten Federkraft beaufschlagbar ist.

2. Vorrichtung nach Anspruch 1, **dadurch gekennzeichnet, dass** das Bauelement (2) auf einem Träger (4) angeordnet ist und das Federsystem (5, 6) am Träger (4) abgestützt ist.

3. Vorrichtung nach Anspruch 2, **dadurch gekennzeichnet, dass** das Federsystem (5, 6) durch zwei zungenförmige Federelemente (5) gebildet ist, wobei jedes Federelement (5) mit einem Ende am Träger (4) verankert ist, an einer zum Bauelement (2) hin liegenden Flachseite jeweils ein Schmelzelement (3) angeordnet ist und am anderen Ende ein elektrischer Kontakt (7) ausgebildet ist, der im Falle, dass das Schmelzelement (3) durch Wärmeeinwirkung schmilzt, die Unterbrechungseinrichtung (14) veranlasst den Strompfad (8) zu unterbrechen.

4. Vorrichtung nach Anspruch 2, **dadurch gekennzeichnet, dass** das Federsystem (5, 6) durch einen U-förmigen Federbügel (6) gebildet ist, der einen Einspannschenkel (15) aufweist, der am Träger (4) eingespannt ist, und einen Druckschenkel (16) aufweist, der mit einer zum Bauelement (2) liegenden Seite mit Federkraft das Schmelzelement (3) an das Bauelement (2) presst, und mit einem Ende auf einen Hebel (12) der Unterbrechungseinrichtung (14) wirkt.

5. Vorrichtung nach Anspruch 3 oder 4, **dadurch gekennzeichnet, dass** das Schmelzelement (3) in einer am Federelement (5) oder am Druckschenkel (6) ausgebildeten Eintiefung (17) angeordnet ist.

6. Vorrichtung nach Anspruch 3, **dadurch gekennzeichnet, dass** der elektrische Kontakt (7) als Schließkontakt oder als Öffnungskontakt ausgebildet ist.

7. Vorrichtung nach Anspruch 4, **dadurch gekennzeichnet, dass** das Bauelement (2) in einer zum Träger (4) hin weisenden Öffnung des U-förmigen Federbügels (5) angeordnet ist und die Unterbrechungseinrichtung (14) einen mechanischen Schalter beinhaltet.

8. Vorrichtung nach Anspruch 3 oder 4, **dadurch gekennzeichnet, dass** das Federelement (5) oder der Federbügel (6) aus einer Blattfeder gebildet ist.

9. Vorrichtung nach einem der Ansprüche 1 bis 8, **dadurch gekennzeichnet, dass** das Schmelzelement (3) aus einem Polymerwerkstoff, besonders bevorzugt aus einem Schmelzklebstoff hergestellt ist.

10. Vorrichtung nach Anspruch 9, **dadurch gekennzeichnet, dass** der Schmelzklebstoff eine Schmelztemperatur aufweist, die kleiner ist als 180 Grad Celsius.
